# EUROPEAN PATENT APPLICATION

(11) **EP 3 839 630 A1**
(43) Date of publication of application: **23.06.2021**
(21) Application number: 19218161.8
(22) Date of filing: 19.12.2019
(51) Int. Cl.: G03F 7/20

(54) **METHODS AND APPARATUS FOR CONFIGURING A LENS MODEL REQUEST**

(71) Applicant: ASML Netherlands B.V., 5500 AH Veldhoven (NL)
(72) Inventor: VAN HINSBERG, Michel, Alphons, Theodorus, Veldhoven (NL); DOWNES, James, Robert, 5500 AH Veldhoven (NL); VERDURMEN, Erwin, Josef, Maria, 5500 AH Veldhoven (NL); KLINKHAMER, Jacob Fredrik Friso, 5500 AH Veldhoven (NL)
(74) Representative: ASML Netherlands B.V.

(57) **Abstract**

A method for determining an input to a lens model to determine a setpoint for manipulation of a lens of a lithographic apparatus when addressing at least one of a plurality of fields of a substrate. The method comprises receiving parameter data for the at least one field, the parameter data relating to one or more parameters of the substrate within the at least one field, the one or more parameters being at least partially sensitive to manipulation of the lens as part of an exposure performed by the lithographic apparatus. The method further comprises receiving lens model data relating to the lens, and determining the input based on the parameter data and on the lens model data.

## Description

### FIELD

The present invention relates to methods and apparatus for determining a request for input to a lens model to determine a setpoint for manipulation of a lens of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

To monitor the quality and performance of a lithographic patterning process, inspections of patterns exposed by the lithographic apparatus may be performed. These inspections can include several types of measurements performed by different types of metrology tools. The measurements may be used to monitor different parameters of the patterned substrate. The measurements may be used to identify one or more errors in the exposed patterns, and associated corrections to a lithographic patterning process may be determined based on the identified errors. These corrections may be applied to the lithographic patterning process in order to improve future exposures performed by the lithographic apparatus. In order to determine how to update a lithographic patterning process, models may be used to link an identified error and/or a desired correction to an update or adjustment to the lithographic process settings. In order to improve the output of the model and obtain better results, the data provided as input to the model may be optimized.

### SUMMARY

In an aspect of the invention a method for determining an input to a lens model to determine a setpoint for manipulation of a lens of a lithographic apparatus when addressing at least one of a plurality of fields of a substrate is provided, the method comprising: receiving parameter data for the at least one field, the parameter data relating to one or more parameters of the substrate within the at least one field, the one or more parameters being at least partially sensitive to manipulation of the lens as part of an exposure performed by the lithographic apparatus; receiving lens model data relating to the lens; and determining the input based on the parameter data and on the lens model.

Optionally, the at least one field may comprise a partial field. The parameter data may comprise parameter data relating to locations inside the partial field. Determining the input may comprise optimizing the input to apply a correction to the one or more parameters, wherein the correction may be identified by the parameter data relating to the locations within the partial field.

Optionally, optimizing the input may comprise determining an initial setpoint inside of the partial field based on a first lens model, wherein the first lens model is based on the lens model data, and evaluating the initial setpoint to determine a setpoint across a portion for a full field outside of the partial field to determine a target setpoint.

Optionally, the first lens model may be further configured to determine an input corresponding to the target setpoint.

Optionally, the first lens model may be a partial field aware lens model configured not to optimize the input for locations outside of the partial field.

Optionally, optimizing the input may comprise determining a plurality of provisional inputs based on the parameter data, and selecting one of the plurality of provisional inputs based on the lens model data.

Optionally, determining one or more of the plurality of provisional inputs may comprise extrapolating parameter data outside of the partial field based on the parameter data inside of the partial field.

Optionally, selecting the one of the plurality of provisional inputs may comprise selecting a provisional input that applies a correction to the parameter that is closest to the correction identified from the parameter data.

Optionally, the correction may be of an error identified in the parameter data.

Optionally, the lens model data may comprise a copy of the lens model.

Optionally, the lens model data may comprise dynamic data for the lens.

Optionally, determining the input may comprise determining an input for a first field based on an input for a second field.

Optionally, the first field may be a partial field and the second field is a full field.

Optionally, the partial field may be adjacent to the full field.

Optionally, the input may be further determined based on dynamic data for the lens and/or an importance of the partial field and/or the full field.

Optionally, the importance of the full field may be greater than an importance of the partial field.

Optionally, the importance of the partial field and/or the full field may be based on the number of structures to be patterned in the field and/or the dimensions of at least a portion of the structures to be patterned in the field.

Optionally, determining the input may comprise optimizing the input to apply a corrections to the parameters in the full field.

Optionally, the parameter data may comprise partial field parameter data and full field parameter data. Optimizing the input may comprise determining an input for the full field based on the full field parameter data, and determining an input for the partial field based on the partial field parameter data and using the input for the full field as a constraint.

Optionally, the parameter data may comprise metrology data.

Optionally, manipulation of the lens may comprise setting a location of one or more lens manipulators, wherein the lens manipulators may be configured to apply a deformation to the lens.

Optionally, the one or more parameters may comprise one or more of overlay data, critical dimension data, levelling data, alignment data, or edge placement error data.

Optionally, the parameter data may be associated with one or more of pattern shift, overlay, alignment aberrations, or focus errors.

Optionally, the method may further comprise providing the input to the lens model, and determining, based on the lens model, the setpoint for manipulation of the lens.

Optionally, the method may further comprise providing the setpoint to the lens. The lithographic apparatus may be configured to perform a lithographic exposure of a substrate using the provided lens setpoint.

According to another aspect of the current disclosure there is provided an apparatus for configuring an input to a lens model for determining one or more settings of a lens of a lithographic apparatus, the apparatus comprising one or more processors configured to perform a method as described above.

According to another aspect of the current disclosure there is provided a lithographic apparatus comprising an apparatus as described above.

According to another aspect of the current disclosure there is provided a lithographic cell comprising an apparatus as described above.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a flow diagram comprising steps in a method of determining an input to a lens model;
- Figure 5(a) depicts a portion of a substrate comprising an edge field;
- Figure 5(b) depicts a schematic representation of extrapolated data;
- Figure 6 depicts a schematic representation of steps in a method for determining a setpoint for manipulation of a lens;
- Figure 7 depicts an example first lens model for determining an input to a lens model;
- Figure 8 depicts an example first lens model for determining an input to a lens model;
- Figure 9 depicts a schematic representation of a portion of a substrate comprising a plurality of fields for which a setpoint has been determined;
- Figure 10 depicts a schematic representation of steps in a method for determining an input to a lens model.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

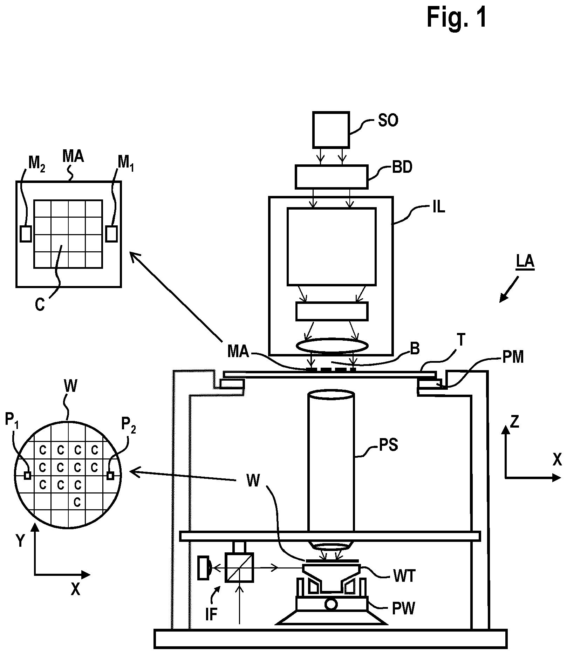

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

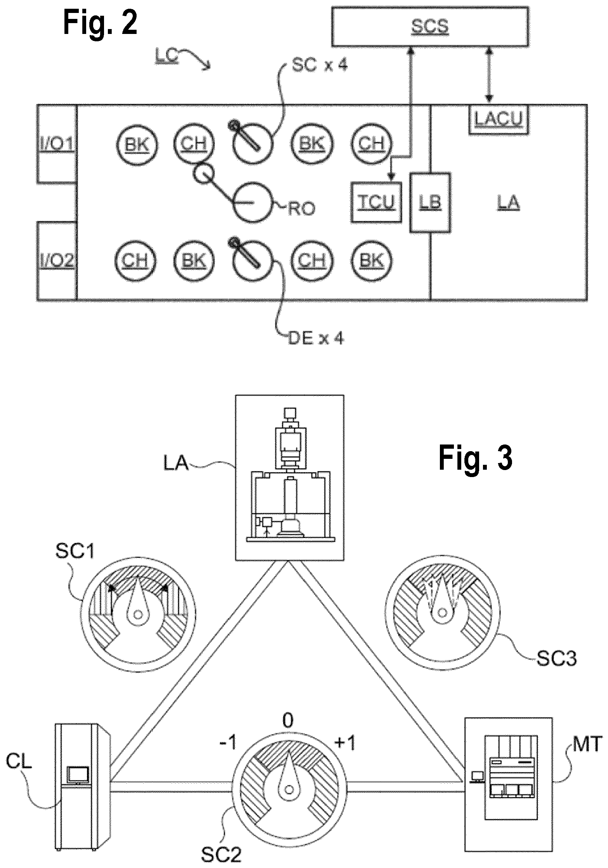

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Different types of metrology tools MT may be used alongside a lithographic apparatus LA, in order to measure different aspects or properties of patterns lithographically exposed on a substrate. Metrology tools MT may use radiation, such as electromagnetic radiation, to interrogate a pattern on a substrate. A metrology tool MT may for example comprise a scatterometer. Example properties that may be measured by a metrology tool TM to determine a quality of an exposure include overlay OVL, alignment AL, and levelling data LVL.

Metrology tools MT may be used to inspect the quality and/or properties of patterns exposed on a substrate. This inspection may be used to detect errors in the exposed pattern. Identified errors may be analysed to determine updates to the settings of the lithographic apparatus, to improve future exposures by the lithographic apparatus, for example by partially or wholly removing the patterning errors from subsequent exposures of the same pattern. One of the elements of a lithographic exposure that may be amended in response to the detection of a patterning error is the properties of the radiation beam used to expose the substrate. A lithographic apparatus may comprise an optical assembly for controlling and manipulating the radiation beam used for a lithographic exposure. The optical assembly may comprise a plurality of optical elements, for example lenses, mirrors, etc. An optical element may have tunable properties that offer control over how the optical element interacts with radiation. The optical assembly may for example comprise a lens having a plurality of lens manipulators. A lens manipulator may be a small element present inside the lens, able to apply small corrections to the properties of the lens (e.g. distortion of field images by the lens). The lens manipulators enable control over how radiation passing through the lens is manipulated by the lens. The setting applied to a lens manipulator, also referred to as the setpoint, may determine how the lens manipulator changes the properties of the lens. A lens manipulator may change the properties of a lens by changing its position in the lens. The changes in properties of the lens as a result of adjustment of positions of one or more lens manipulators may in turn adjust how radiation passing through the lens is controlled. The setpoint may determine the position of the lens manipulator to achieve the desired optical effect in the lens.

Metrology data may be of a lithographically patterned substrate. Metrology data may comprise data relating to one or more parameters of the substrate and/or a structure patterned on the substrate. This may be referred to as parameter data. Next to metrology data, other forms of parameter data may be provided for a substrate, for example simulated parameter data. One or more corrections for a pattern may be determined based on parameter data. The parameter data may be of a previous exposure of a pattern on one or more substrates. The pattern of the one or more previous exposures may be the same as the pattern to be exposed. The parameter data may comprise metrology data and/or simulation data of an exposed pattern on a substrate. The parameter data may be provided for a plurality of locations across the substrate.

Based on the parameter data, errors in the parameter values present in the parameter data may be identified. This may for example be done by comparing the parameter data for a substrate to expected values of those parameters. Errors of parameter data may represent aberrations of parameter values of a substrate that deviate from expected values for those parameters. The parameter data may comprise data relating to an error in a parameter value in addition to or alternatively to parameter values themselves. The identified errors may also be considered an indication of corrections to be applied to an exposed pattern in order to remove the identified error. The corrections to a pattern may be translated into corrections to a lithographic patterning process for exposing that pattern. These corrections may be applied to a lithographic patterning process so that future exposures of the same pattern as the one for which parameter data was provided can be improved.

Identified errors and associated corrections to be applied to a patterned substrate may relate to a parameter affected by a manipulation of a lens controlling radiation performing a lithographic patterning process. Examples of substrate parameters that may be affected by manipulation of a lens include overlay OVL, critical dimension CD (line thickness), alignment AL, levelling LVL, and edge positioning errors EPE. Identified issues in the parameters may for example be associated with a pattern shift, overlay errors, alignment errors, and/or focus errors in the pattern, or a levelling issue on the substrate. It will be understood that these examples are not exhaustive, and other parameters and/or causes of errors may be used and identified.

In order to translate an identified error/correction or determined desired setpoint for a lens, a lens model may be used. The lens model may receive as input a request for a correction of one or more errors identified for a lithographic exposure of a substrate. The lens model may output a setpoint to be applied to the lens and/or a lens manipulator, based on the received input. The substrate may be divided into a plurality of exposure fields, also referred to as fields. Fields on a substrate may be exposed separately during a lithographic exposure, for example one by one. Separate exposure settings may be applied for separate fields. The lens may for example be used to expose different fields on a substrate in series. An exposure field may therefore be said to have previous and subsequent fields, which are fields exposed before and after that field, respectively. Previous and subsequent fields may also be referred to as preceding and succeeding fields in a series of field exposures. Previous and subsequent fields in a series may be neighbouring fields on the substrate. The request may provide different setpoints for different fields to be exposed, so that different corrections may be applied for different fields. A lens model may receive as input a request relating to error corrections for a plurality of fields to be exposed sequentially. The request for each field may be based on parameter data for that field. For example, each field on a substrate may comprise one or more metrology targets, which may be measured by a metrology tool MT to determine properties of the pattern exposed on that field. The metrology target may for example be an overlay metrology target. Metrology data may be based on measurements of features other than metrology targets, for example on measurements of product features. Alternatively or additionally, the parameter data may comprise simulation data for one or more fields.

The lens model may be used during operation of the lithographic apparatus LA. Parameter data related to one or more previous exposures performed by the apparatus may be provided to the lens model, to update the setpoint and to apply corrections identified based on previous exposures. To avoid delays to the lithographic exposure process, it may be desirable to limit the amount of computational time needed by the model. The lens model may therefore have certain limitations applied to it to reduce its computational cost. This may also lead to suboptimal performance of the lens model and/or make the lens model less flexible or adaptable. The lens model may for example be designed to calculate settings for fields on a substrate without taking into account setpoints for previous and/or subsequent fields exposed using the lens. The lens model may also assume that all fields on a substrate have the same shape, for example a rectangular shape. As a result, the lens model may be designed to receive a request for a field with a rectangular or other predetermined shape, and may not be able to process inputs with a different shape. This may pose an issue for fields on the edge of a substrate, which are typically not rectangular due to the common circular disk shape of a substrate. In order to provide a request for an edge field of a substrate to a lens model, the metrology data may only be available for a portion of the expected field shape. The portion of an edge field of a substrate that is taken up by the substrate may be referred to as a partial field. An extrapolation of parameter data available for the portion of the expected field shape not filled by the substrate may be used to create a request fitting a field of the expected shape, e.g. a rectangular shape. The extrapolation may for example be a polynomial extrapolation, wherein the extrapolation is based on the metrology data as input.

Receiving an extrapolated request for an edge field as an input, the lens model may determine a setpoint to be applied by a lens for exposing the field of the substrate. The extrapolated portion of the field represents a virtual portion of the request, as it does not correspond to a substrate exposure. Therefore, the quality of the correction applied by the setpoint to this virtual portion does not matter, as it does not correspond to an area on the substrate. However, a lens model that has been designed to be computationally faster, may be designed to process each input field in the same way. As a result, the lens model may treat each input as part of the same request

. The lens model may not be able to distinguish between the virtual portion of the request and the portion of the request representing the partial field. The lens model will treat the virtual portion and partial field portions of the request the same. The lens model will give equal value to the partial field portion and virtual portion of the request. The setpoint may not be able to fully fit to the correction included in the request. The lens model may try to find a best fit to the entire request, fitting to both the partial field and virtual portions of the request. However, fitting to the virtual portion of the request provides no real-term benefits to the quality of the corrections applied by the setpoint. Fitting to an extrapolated field may even result in a setpoint leading to an exposure with worse errors than before the corrections were applied. The methods and apparatus described herein aim to provide an improved requests for a lens model to determine setpoint for a lens.

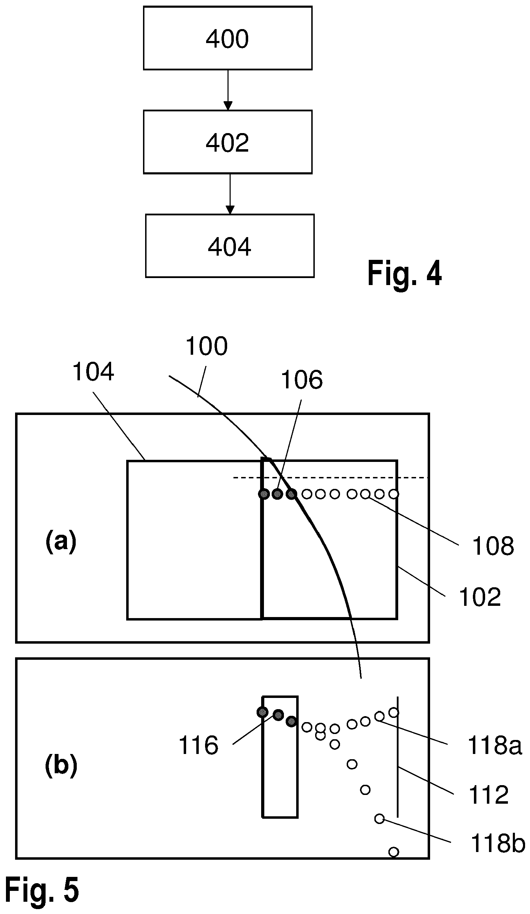

Figure 4 depicts a flowchart comprising steps in a method for determining an input to a lens model. The input may be determined as a request for providing to a lens model. The lens model may determine a setpoint for manipulation of a lens of a lithographic apparatus for at least one of a plurality of fields of a substrate. The methods described herein may be performed by one or more processors executing a series of instructions saved in a storage medium. The processors may be provided separate from the lithographic apparatus LA and/or a metrology tool MT.

In step 400, parameter data is received for the at least one field on the substrate. The parameter data relates to one or more parameters of the substrate within the at least one field. The one or more parameters may be at least partially sensitive to manipulation of the lens as part of an exposure performed by the lithographic apparatus. In step 402, the method receives lens model data relating to the lens. The lens model data may comprise a copy of the lens model, and/or may comprise other data characterizing the lens model. In step 404 the method determines the request based on the received parameter data and lens model data. Once determined, the request may be provided as input to a lens model. The lens model may then determine a setpoint based on the received request. The lens model may determine a setpoint per field. The setpoint may be applied to a lithographic apparatus LA for a lithographic exposure for patterning a structure onto a substrate. The structure to be patterned may have the same intended design as the structure for which the parameter data was received.

An advantage of the method as depicted in figure 4 may be that an input can be determined that takes into account specifics of the lens model. The request to be input may be determined offline, that is to say, separate from the lithographic apparatus and lens model. An advantage of determining an input offline, for example using one or more offline calculations may be that more computing time is available, allowing more time consuming (e.g. complex) calculations to be used for determining the input. This may increase the quality of the resulting input. The request may for example be determined to optimize the setpoint based on the characteristics of the lens model. The lens model data may for example be used to determine an extrapolation leading to a setpoint determination that provides a good fit for a partial field. The lens model data may alternatively or additionally be used to take into account setpoints for one or more previous and/or subsequent fields, to be exposed before and/or after the field. Ways in which the request may be optimised based on a combination of metrology data and lens model data will be set out in more detail below.

The parameter data may comprise one or both of metrology data and simulated data. The parameter data may be obtained for one or more previous lithographically patterned substrates. The parameter data may comprise data that identifies an error in a parameter of a structure patterned within the at least one field, using the lithographic apparatus. The parameter data may for example comprise a fingerprint for one or more parameters, wherein a fingerprint may comprise data associated with one or more of a pattern shift, an overlay error, an alignment error, and/or a focus error.

The at least one field may comprise a partial field. The partial field may be an edge field on the substrate, as depicted in figure 5. Figure 5(a), shows a portion of a substrate 100, indicating a plurality of fields. The fields may all have the same size. The image depicts an edge field 102, wherein the edge field is only partially filled by the substrate 100. An inner field 104 is also illustrated in which the substrate 100 covers the entire field. In the edge field, parameter data may be provided at locations 106 that are covered by the substrate. The locations 108 in the portion of the field not covered by the substrate 100 do not have parameter data available. However, the lens model may expect the request to provide input for these points. An extrapolation may be determined to provide values for the locations 108 in the portion of the edge field 102 not covered by substrate 100. Figure 5(b) shows a schematic representation of extrapolated data, based on parameter data. The extrapolated data may be used to create requests 112, which may be referred to as extrapolated requests 112. The extrapolated requests 112 may each be in the required format to be input to the lens model. Each of the extrapolated requests comprises the parameter data 116 available for the partial field covered by the substrate. The requests 112 also depict a plurality of different possible extrapolations 118a, 118b for the locations not covered by substrate 100. The extrapolations 118a, 118b may be based on the parameter data 116. The parameter data 116 may comprise parameter data, such as metrology data, relating to locations inside the partial field. Determining the request may comprise optimising the request to apply a correction to the one or more parameters. The correction may be identified by the parameter data relating to the locations within the partial field. The correction may be a correction of an error identified in the parameter data. This may for example involve determining which of the plurality of possible extrapolations 118a, 118b provides the best setpoint fit to correct at the locations 106 of the partial field.

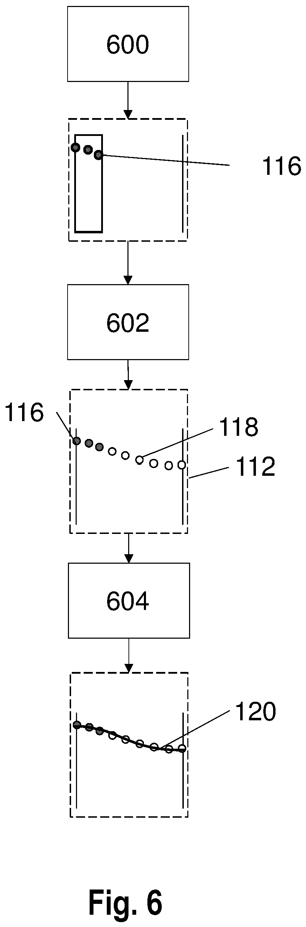

The steps to optimize the request may be performed using a first lens model based on the lens model data. Figure 6 depicts a schematic representation of steps in a method for determining a setpoint 120 for manipulation of a lens, and entities that perform them. A metrology tool MT and/or simulation tool 600 may provide parameter data 116 relating to one or more parameters of the substrate. The parameter data may be provided to a first lens model 602. The first lens model 602 may be determined based on the lens model data. The first lens model 602 may determine a setpoint. The first lens model 602 may optimize the setpoint inside the partial field. To optimize a setpoint inside the partial field, the first lens model 602 may determine an initial setpoint based on the parameter data 116. The initial setpoint may be determined for the portion of the field covered by the partial field. The first lens model 602 may then evaluate the initial setpoint and determine a setpoint across a full field. The setpoint for the full field may comprise the initial setpoint for the partial field. The first lens model 602 may also determine a request 112 corresponding to the determined setpoint. The request 112 may also be referred to as an extrapolated request, due to the extrapolation applied to obtain extrapolated data 118 of the request. The request 112 may also be referred to as an optimized request or and optimized extrapolated request, due to the optimization step applied by the first lens model 602 to determine the request. The request 112 may be provided as input to a lens model 604 for a lithographic apparatus LA. The lens model may determine a setpoint 120 for manipulation of the lens. The determined setpoint 120 may be provided and implemented to the lens of the lithographic apparatus LA. Figure 6 shows a comparison of the correction obtained by applying the setpoint 120 and the request 112. The quality of the request 112 may affect how well the corrections applied by the setpoint 120 address the errors identified by the parameter data 116. The quality of the fit of the setpoint 120 to the request may also affect how well the corrections applied by the setpoint 120 address the errors identified by the parameter data 116.

The first lens model 602 may be based on the lens model data. The first lens model may combine the lens model data with the parameter data 116 to determine the extrapolated request 112. The first lens model 602 may comprise a copy of the lens model. The first lens model may alternatively or additionally use knowledge of the structure and/or function of the lens model, provided by the lens model data, to determine or estimate the effect of the lens model on a request. The first lens model 602 may be applied offline, that is to say, separately from the running of the lithographic apparatus LA and the manipulation of the lens. For example, a first lens model may be used for determining a request before starting a lithographic exposure. This may provide the first lens model 602 with additional computation time to determine setpoints, compared to a situation where the lens model 604 receives and processes inputs during a lithographic exposure. This allows the first lens model 602 to be more computationally complex than the lens model 604.

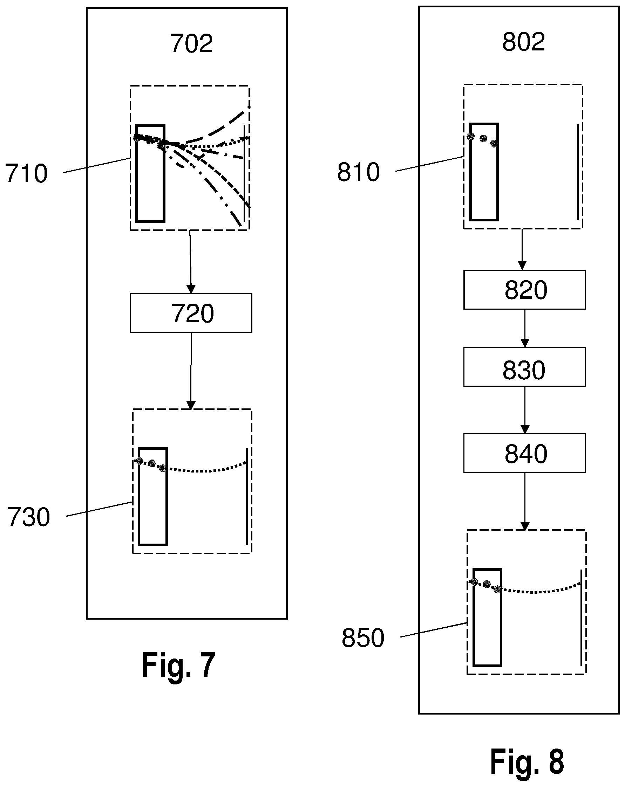

Figure 7 depicts an example first lens model 702, which may be based on a brute force method. The first lens model 702 may determine a plurality of extrapolated requests 710 based on the parameter data 116 for a partial field 102. The extrapolations may cover the portion of the field outside of the partial field. The plurality of extrapolated requests 710 may be referred to as provisional inputs, or provisional requests. The lens model data may comprise a copy 720 of the lens model. Each of the determined provisional requests 710 may be provided as input to the copy of the lens model 720. The copy of the lens model 720 may determine a setpoint for each of the extrapolated requests 710. The first lens model 702 may then determine the preferred setpoint from the plurality of determined setpoints. Determining the preferred setpoint may for example comprise determining the setpoint which most accurately implements corrections in the partial field covered by the substrate 100. The provisional request that applies a correction that is closest to the correction identified from the parameter data 116 may be selected. The provisional request providing the preferred setpoint may be selected as the optimised request 730. This optimised request 730 may be provided to the lens model of the lithographic apparatus LA. Determining the preferred setpoint may also take into account the impact of the setpoint associated with each of the provisional requests on a subsequent field to be exposed.

Figure 8 depicts a second example implementation of steps performed by a first lens model 802. The first lens model may comprise a partial field aware lens model 820 for determining a setpoint based for an edge field. A partial field aware model 820 may be based on the lens model. A partial field aware lens model 820 may take into account that it does not need to optimize that part of the field outside of the substrate. The partial field aware model 820 may be able to receive inputs with a partial field shape 810, for example having less parameter data 116. The partial field aware model 820 may be able to determine a setpoint 830 for the lens based on the partial field input 810, without needing an extrapolation of data into the remaining portion of the field. An advantage of this approach may be that the determined setpoint 830 may be optimised for the partial field.

The determined setpoint 830 may be based on parameter data 116, without being based on extrapolated data. The setpoint 830 has not been fitted to extrapolated values in a virtual portion of the field. The first lens model 802 may further evaluate 840 the optical effects on the full field of the requested setpoint values outside of the partial field that are a result of optimizing the request for partial field covering the substrate. The setpoint for the full field may be used to determine a corresponding request that has a suitable format to be input to the lens model. This may involve evaluating the effects of the setpoint 830 over the full field, and using the resulting effects as the request for input to the lens model. The first lens model 802 may determine this as an extrapolated request 850 that when input to the lens model, outputs a setpoint matching the optimised setpoint 830 determined by the partial field aware model 820. In some instances the extrapolated request 850 may lead to an output matching the optimised setpoint 830. In other instances, the extrapolated request 850 may lead to an output closely resembling the optimized setpoint 830. The determined extrapolated request 850 may be provided as input to the lens model of the lithographic apparatus LA. A partial field aware lens model 820 may use information about the exposure route of fields on a substrate. This information may be provided as part of the lens model data.

A plurality of setpoints for manipulation of a lens may be determined for a plurality of fields. A different setpoint may be determined for each field on a substrate. The fields may be exposed in series by the lithographic apparatus. Subsequent fields may be exposed in quick succession, meaning the time available to adjust the setpoint between subsequent field exposures may be limited. Furthermore, the dynamic properties for the manipulation of the lens may also be limited. For example, the speed and range by which lens manipulators are able to move across the lens may be limited. As a result, it may not be possible to implement large variations between subsequent setpoints. If a variation between two or more neighbouring setpoints is large, the accuracy by which the lens implements the setpoint may be reduced. This may in turn reduce the accuracy of the corrections applied by the manipulation of the lens, which may negatively affect the quality of the resulting pattern. In order to address this challenge, the request determined for one field, may take into account the requests determined for one or more neighbouring fields.

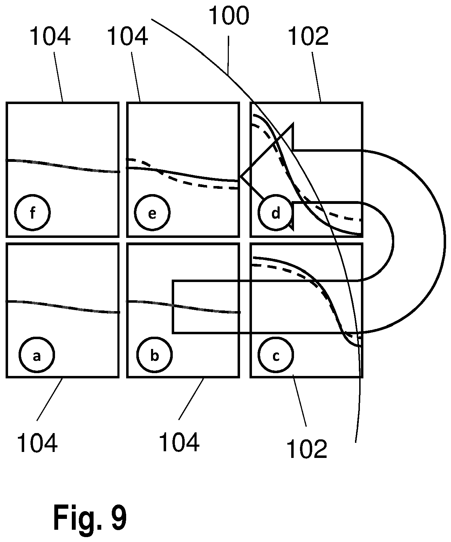

Figure 9 depicts a schematic representation of a portion of a substrate 100. The portion comprises a plurality of edge fields 102 and inner fields 104. An arrow indicates an order (alphabetical order from a to f) in which the fields are programmed to be exposed by the lithographic apparatus LA. A setpoint is determined for each of the fields. The determined setpoint is depicted in figure 9 as a solid line. If setpoints for different fields are determined independently from each other, they may have large variations between them. As shown in figure 9, the setpoints determined for the edge fields 102 vary strongly from the setpoints determined for the inner fields 104. The system for manipulating the lens may not be able to apply such strong variations for consecutive fields.

In order to address potential problems with subsequent setpoints not being compatible with each other, a setpoint for a first field may be based on a setpoint for one or more second fields. The one or more second fields may be neighbouring fields. Neighbouring fields may be fields that are programmed to be exposed before and/or after the field. Neighbouring fields may be fields that are adjacent to each other. The lens model data may comprise data to allow setpoints of neighbouring fields to be taken into account. The lens model data may for example comprise dynamic data for the lens. Dynamic data may include information about the speed and range of variations in manipulation that can be applied. This may for example include the speed by which lens manipulators may move. Dynamic data for the lens may be used to determine whether a plurality of setpoints for a plurality of fields can be applied to the lens successfully. If one or more of the variations between subsequent setpoints is not suitable to be implemented by a lens, adjustments may be made to one or more of the setpoints. In figure 9, adjusted setpoints are depicted as a dashed line. For example, in figure 9, the setpoints for edge fields 102 (fields c and d), may be adjusted to have a smaller variation compared to the previous field b, and subsequent field e. Adjustments may also be made to inner fields b and e, to accommodate the larger setpoint variation at edge fields c and d.

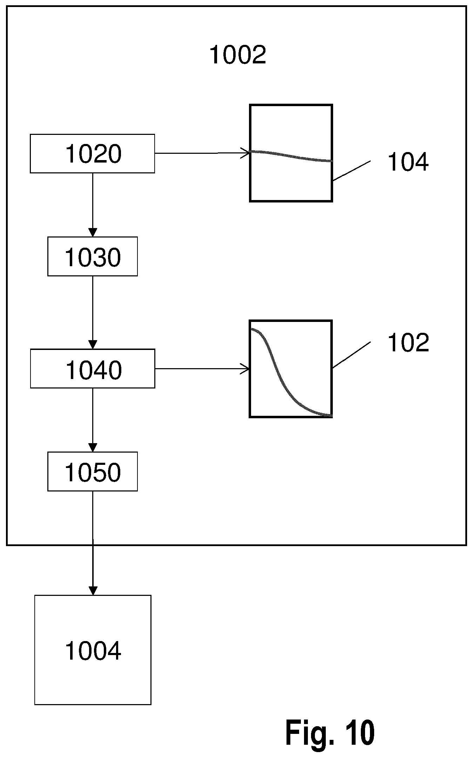

Figure 10 depicts a schematic representation of steps in a method for determining an input to a lens model wherein a setpoint for a field may be determined based on a setpoint for one or more other fields. A first lens model 1002 may be provided to determine an input for the lens model 1004. The first lens model may determine, using a first module 1020, a setpoint 1030 for one or more inner fields 104. The lens model may use at least a portion of the lens model data available to it to determine a setpoint 1030 for the one or more inner fields 104. The lens model may then provide the determined setpoints 1030 to a second module 1040. The second module may use at least a portion of the lens model data and the determined setpoints 1030 for the one or more inner fields to determine a setpoint for one or more edge fields 102. Based on the lens model data and the setpoints for the inner fields 104, the second module may determine the setpoints for the edge fields 102 that are possible to be applied to the lens. The setpoints 1050 for the inner fields 104 and edge fields may be provided to the lens model 1004 to be applied during a lithographic apparatus LA.

The first lens model 1002 may be provided with information relating to an importance of fields relative to each other. For example, a partial field may have a lower importance than a full field. This may be because the full field has more available area, and may therefore contain more patterned product features. An importance may be allocated based on the design of a pattern to be exposed on the substrate 100. The importance may for example correspond to the amount of structures to be patterned in the field, The importance may additionally or alternatively correspond to a dimension of at least a portion of the structures to be patterned in the field. For example, structures with smaller critical dimensions may be allocated a greater importance due to the more stringent patterning requirements for exposing those structures.

A field may be divided into several regions, wherein different regions may have a different importance allocated to them. The first lens model may use the relative importance to determine a setpoint in a field. For example, a first region within a field may be allocated a higher importance relative to a second region in that field. For example, a region in a field comprising a design of structures with smaller dimensions may be allocated a greater importance compared to a region with structures with bigger dimensions. The first lens model 1002 may prioritise optimising the setpoint for the first region over the second region.

The importance of fields and/or regions in a field on a substrate relative to each other may be provided to a first lens model 1002 as part of the parameter data 116. A first lens model may use the information on relative importance of fields to determine a setpoint. A first lens model 1002 may for example determine an initial setpoint for a plurality of fields. The first lens model 1002 may then use lens model data to determine whether the variations between subsequent fields are possible to be applied to the lens. If the lens manipulation is not able to reliably apply the initial determined variations, the first lens model may use this information to determine one or more adjustments to the initial setpoints. The adjustments may take into account a relative importance of fields and/or regions within a field.

In an example implementation, a first lens model may be used to, in a first step, determine a plurality of setpoints for a plurality of fields. In a further step, the first lens model may use the plurality of setpoints, and dynamic data relating to the lens model manipulation, to determine whether the manipulation of the lens is able to apply the variation between subsequent setpoints. The first lens model may then determine one or more adjustments to the setpoints, to provide updated setpoints. The updated setpoints may be provided as input to the lens model.

As described herein, a first lens model may be used to optimize an input to be provided to a lens model for manipulating the lens. The functions of a first lens model 602, 702, 802, 1002 as described herein may be combined. For example, the first lens model may use extrapolation methods to determine inputs covering a full field for partial fields, and may also use neighbouring fields to determine and/or adjust a setpoint for a field. An exemplary method as described herein may comprise determining an input for a lens model for one or more full fields for the full field based on parameter data for the full field. The method may then determine a input for the lens model or one or more partial fields, for example using the extrapolation methods described above. For the determination of the input for the partial fields, the input for the full fields may be used as a constraint.

Parameter data may relate to errors in a pattern exposed on a substrate. The parameter data may comprise information indicating errors directly. Alternatively or additionally, errors may be determined based on the metrology data. This may for example be done by comparing metrology data to expected values for the metrology data in case of an error-free patterned structure.

The one or more parameters may comprise overlay OVL. The method may provide parameter data for a plurality of parameters, for example including overlay OVL, alignment AL, levelling data LVL, edge placement error data EPE, data relating to focus, etc. The parameter data may comprise metrology data. Metrology data may be obtained by different metrology tools MT. The metrology data may be obtained for structures patterned by the same lithographic apparatus LA as the one for which the lens model request is determined. The parameter data may alternatively or additionally comprise simulated data relating to patterns exposed on a substrate. The simulated data may be based on metrology data. The parameter data may relate to a previous iteration of a lithographic exposure of the same pattern, as the pattern for which the lens model request is being determined. This may allow updating of an exposure process based on data related to one or more previous iterations of the same exposure process. The parameter data may be associated with one or more of a pattern shift, overlay errors, alignment aberrations and/or focus errors.

The lens model data may comprise information about the lens model. The lens model data may comprise a copy of the lens model. The lens model data may comprise dynamic data for the lens. Dynamic data for the lens model may include information on how the lens performance changes based on adjustments the setpoint for the lens. This information may comprise information about for example regarding speed by which a setpoint can be adjusted, or time of exposure.

Further embodiments of the invention are disclosed in the list of numbered clauses below:
1. A method for determining an input to a lens model to determine a setpoint for manipulation of a lens of a lithographic apparatus when addressing at least one of a plurality of fields of a substrate, the method comprising:
   receiving parameter data for the at least one field, the parameter data relating to one or more parameters of the substrate within the at least one field, the one or more parameters being at least partially sensitive to manipulation of the lens as part of an exposure performed by the lithographic apparatus;
   receiving lens model data relating to the lens;
   determining the input based on the parameter data and on the lens model data.
2. A method according to clause 1, wherein the at least one field comprises a partial field, and the parameter data comprises parameter data relating to locations inside the partial field;
   and wherein determining the input comprises optimizing the input to apply a correction to the one or more parameters, wherein the correction is identified by the parameter data relating to the locations within the partial field.
3. A method according to clause 2, wherein optimizing the input comprises:
   determining an initial setpoint inside of the partial field based on a first lens model, wherein the first lens model is based on the lens model data; and
   evaluating the initial setpoint to determine a setpoint across a portion for a full field outside of the partial field to determine a target setpoint.
4. A method according to clause 3, wherein the first lens model is further configured to determine an input corresponding to the target setpoint.
5. A method according to any of clauses 3 or 4, wherein the first lens model is a partial field aware lens model configured not to optimize the input for locations outside of the partial field.
6. A method according to any of clauses 2 to 5, wherein optimizing the input comprises:
   determining a plurality of provisional inputs based on the parameter data; and
   selecting one of the plurality of provisional inputs based on the lens model data.
7. A method according to clause 6, wherein determining one or more of the plurality of provisional inputs comprises extrapolating parameter data outside of the partial field based on the parameter data inside of the partial field.
8. A method according to clause 6 or 7, wherein selecting the one of the plurality of provisional inputs comprises selecting a provisional input that applies a correction to the parameter that is closest to the correction identified from the parameter data.
9. A method according to clause 8, wherein the correction is of an error identified in the parameter data.
10. A method according to any of the preceding clauses, wherein the lens model data comprises a copy of the lens model.
11. A method according to any of the preceding clauses, wherein the lens model data comprises dynamic data for the lens.
12. A method according to any of the preceding clauses, wherein determining the input comprises determining an input for a first field based on an input for a second field.
13. A method according to clause 12, wherein the first field is a partial field and the second field is a full field.
14. A method according to clause 13, wherein the partial field is adjacent to the full field.
15. A method according to any of clauses 12 to 14, wherein the input is further determined based on dynamic data for the lens and/or an importance of the partial field and/or the full field.
16. A method according to clause 15, wherein the importance of the full field is greater than an importance of the partial field.
17. A method according to clause 11 or 12, wherein the importance of the partial field and/or the full field is based on the number of structures to be patterned in the field and/or the dimensions of at least a portion of the structures to be patterned in the field.
18. A method according to any of clauses 13 to 17, wherein determining the input comprises optimizing the input to apply a corrections to the parameters in the full field.
19. A method according to clause 18, wherein the parameter data comprises partial field parameter data and full field parameter data, and wherein optimizing the input comprises:
   determining an input for the full field based on the full field parameter data; and
   determining an input for the partial field based on the partial field parameter data and using the input for the full field as a constraint.
20. A method according to any of the preceding clauses, wherein the parameter data comprises metrology data.
21. A method according to any of the preceding clauses, wherein manipulation of the lens comprises setting a location of one or more lens manipulators, wherein the lens manipulators are configured to apply a deformation to the lens.
22. A method according to any of the preceding clauses, wherein the one or more parameters comprises one or more of overlay data, critical dimension data, levelling data, alignment data, or edge placement error data.
23. A method according to clause 22, wherein the parameter data is associated with one or more of pattern shift, overlay, alignment aberrations, or focus errors.
24. A method according to any of the preceding clauses, further comprising:
   providing the input to the lens model; and
   determining, based on the lens model, the setpoint for manipulation of the lens.
25. A method according to clause 24, further comprising
   providing the setpoint to the lens,
   wherein the lithographic apparatus is configured to perform a lithographic exposure of a substrate using the provided lens setpoint.
26. An apparatus for configuring an input to a lens model for determining one or more settings of a lens of a lithographic apparatus, the apparatus comprising one or more processors configured to perform a method according to any of clauses 1 to 25.
27. A lithographic apparatus comprising an apparatus according to clause 26.
28. A lithographic cell comprising an apparatus according to clause 27.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays. As an alternative to optical metrology methods, it has also been considered to use X-rays, optionally hard X-rays, for example radiation in a wavelength range between 0.01nm and 10nm, or optionally between 0.01nm and 0.2 nm, or optionally between 0.1nm and 0.2nm, for metrology measurements.

## Claims

1. A method for determining an input to a lens model to determine a setpoint for manipulation of a lens of a lithographic apparatus when addressing at least one of a plurality of fields of a substrate, the method comprising:
receiving parameter data for the at least one field, the parameter data relating to one or more parameters of the substrate within the at least one field, the one or more parameters being at least partially sensitive to manipulation of the lens as part of an exposure performed by the lithographic apparatus;
receiving lens model data relating to the lens;
determining the input based on the parameter data and on the lens model data.

2. A method according to claim 1, wherein the at least one field comprises a partial field, and the parameter data comprises parameter data relating to locations inside the partial field;
and wherein determining the input comprises optimizing the input to apply a correction to the one or more parameters, wherein the correction is identified by the parameter data relating to the locations within the partial field.

3. A method according to claim 2, wherein optimizing the input comprises:
determining an initial setpoint inside of the partial field based on a first lens model, wherein the first lens model is based on the lens model data; and
evaluating the initial setpoint to determine a setpoint across a portion for a full field outside of the partial field to determine a target setpoint.

4. A method according to claim 3, wherein the first lens model is further configured to determine an input corresponding to the target setpoint.

5. A method according to any of claims 3 or 4, wherein the first lens model is a partial field aware lens model configured not to optimize the input for locations outside of the partial field.

6. A method according to any of claims 2 to 5, wherein optimizing the input comprises:
determining a plurality of provisional inputs based on the parameter data; and
selecting one of the plurality of provisional inputs based on the lens model data.

7. A method according to claim 6, wherein determining one or more of the plurality of provisional inputs comprises extrapolating parameter data outside of the partial field based on the parameter data inside of the partial field.

8. A method according to claim 6 or 7, wherein selecting the one of the plurality of provisional inputs comprises selecting a provisional input that applies a correction to the parameter that is closest to the correction identified from the parameter data.

9. A method according to claim 8, wherein the correction is of an error identified in the parameter data.

10. A method according to any of the preceding claims, wherein determining the input comprises determining an input for a first field based on an input for a second field.

11. A method according to claim 10, wherein the first field is a partial field and the second field is a full field.

12. A method according to claim 11, wherein the input is further determined based on dynamic data for the lens and/or an importance of the partial field and/or the full field.

13. A method according to claim 12, wherein the importance of the full field is greater than an importance of the partial field.

14. A method according to any of the preceding claims, wherein the one or more parameters comprises one or more of overlay data, critical dimension data, levelling data, alignment data, or edge placement error data.

15. A method according to claim 14, wherein the parameter data is associated with one or more of pattern shift, overlay, alignment aberrations, or focus errors.
